# EUROPEAN PATENT APPLICATION

(11) **EP 2 467 002 A2**
(43) Date of publication of application: **20.06.2012**
(21) Application number: 11194069.8
(22) Date of filing: 16.12.2011
(51) Int. Cl.: H05K 3/30

(54) **Electronic component on-substrate mounting structure**

(30) Priority: 20.12.2010 JP 2010283149
(71) Applicant: Panasonic Electric Works Co., Ltd., Kadoma-shi Osaka 571-8686 (JP)
(72) Inventor: Kinugasa, Noriaki, Himeji, Hyogo (JP); Konishi, Jun, Himeji, Hyogo (JP); Ogawa, Masanori, Himeji, Hyogo (JP)
(74) Representative: Rüger, Barthelt & Abel

(57) **Abstract**

[Object] An electronic component on-substrate mounting structure capable of mounting an electronic component having a round external shape on a substrate in a predetermined attitude and keeping an allowance of a lead to a predetermined value is provided.

[Means for Settlement] A lead 12 of an electronic component 11 is inserted into a lead hole 31 of a substrate 30, thereby mounting the electronic component 11 on the substrate 30. The lead 12 includes a base part 16 extending from an electronic component main body 13, a support part 17 bent from the base part 16, abutting an electronic-component mount surface 30A of the substrate 30 at a predetermined length, and supporting the electronic component main body 13, and an insertion part 18 bent from the support part 17 and inserted into a lead hole 31 of the substrate 30.

## Description

### [Field of the Invention]

The present invention relates to a mounting structure for mounting an electronic component on a substrate.

### [Background Art]

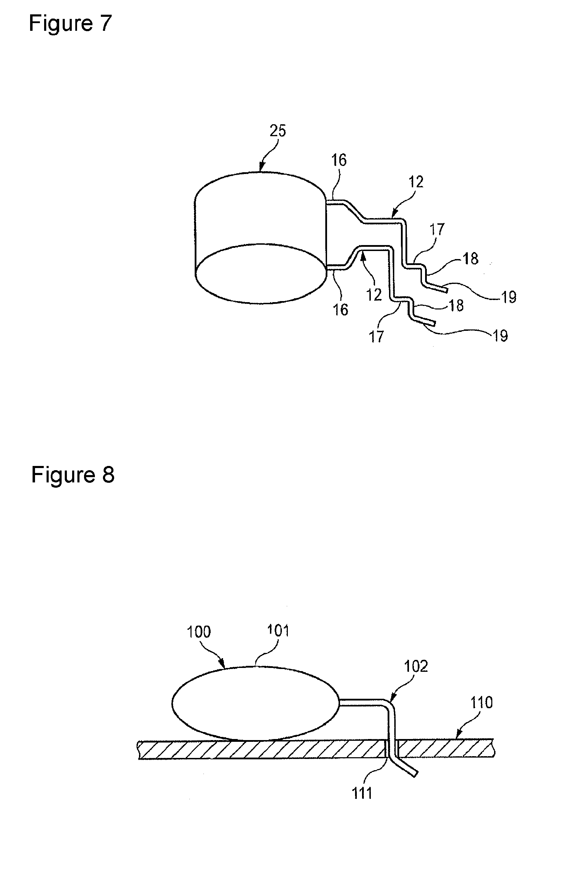

There is conventionally proposed an on-substrate mounting structure. As shown in Fig. 8, if a tall electronic component 100 is mounted on a substrate 110, then an electronic component main body 101 is arranged so that a longitudinal direction of the electronic component main body 101 is parallel to the substrate 110, and a lead 102 extending laterally from the electronic component main body 101 is bent and inserted into a lead hole 111 of the substrate 110, thereby making an overall height of the electronic component main body 101 small (see, for example, Patent Literature 1).

### [Conventional Technique Document]

### [Patent Literature]

[Patent Literature 1] JPAHeisei 11-163493 (Claim 1; Page 2, right column; and Figs. 1 and 2)

### [Disclosure of the Invention]

### [Problems to be solved by the Invention]

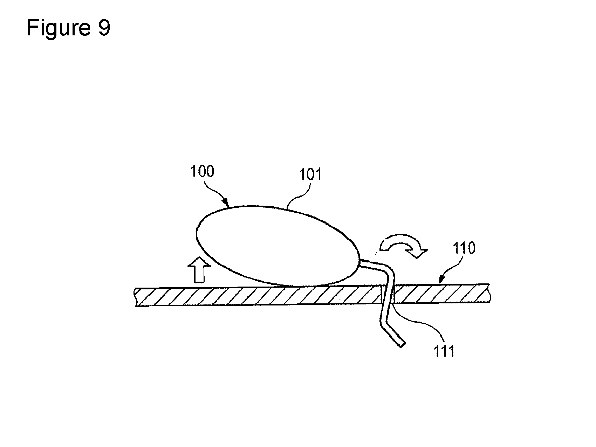

However, the electronic component on-substrate mounting structure described in JPA Heisei 11-163493 has the following problems. As shown in Fig. 9, if the electronic component 100 having a round external shape such as an electrolytic capacitor or a film capacitor is mounted on the substrate 110 with a round portion thereof opposing the substrate 110, problems occur such as one that the round external portion of the electronic component main body 101 abuts the substrate 110 and the electronic component main body 101 is arranged in an inclined attitude. Due to this, the electronic component 100 cannot be kept in a predetermined attitude.

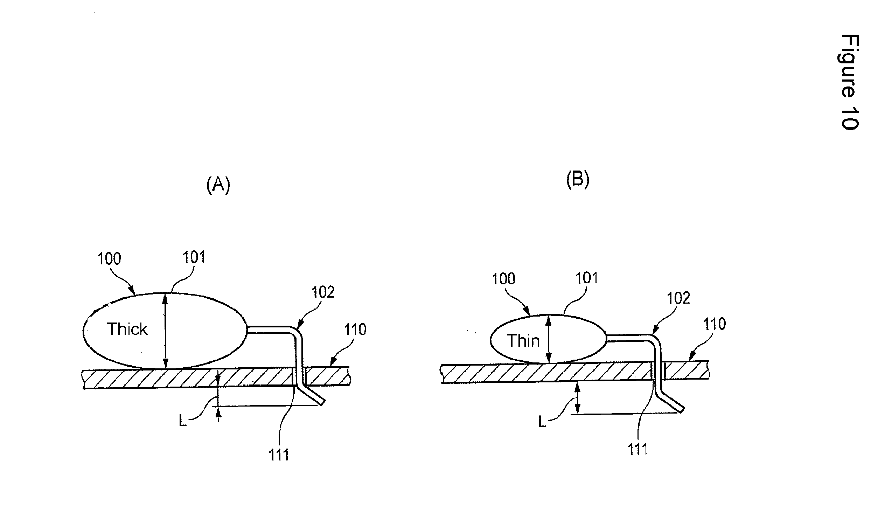

Furthermore, as shown in Figs. 10(A) and 10(B), the electronic component main body 101 often differs in a thickness in a width direction of the electronic component main body 101 for reasons such as a change in finished dimensions of the electronic component main body 101. In this case, as shown in Fig. 10(B), dimensions L of an allowance of the lead 102 protruding to a rear side of the substrate 110 become possibly excessively large.

If the allowance of the lead 102 is excessively large in dimensions, problems such as one that the allowance of the lead 102 is caught in a nozzle of a tank and one that a sufficient insulation distance of the electronic component 100 to a case (not shown) containing the electronic component 100 cannot be kept possibly occur.

It is an object of the present invention to provide an on-substrate mounting structure for an electronic component capable of supporting an electronic component main body in a predetermined attitude and suppressing an allowance of a lead from becoming excessively large in dimensions even if the electronic component is mounted on a substrate with a round portion of the electronic component opposing the substrate.

### [Means adapted to solve the Problems]

The present invention is an electronic component on-substrate mounting structure for mounting an electronic component on a substrate by inserting a lead of the electronic component into a lead hole of the substrate, wherein the lead includes: a base part extending from the electronic component main body; a support part supporting the electronic component by abutting on an electronic-component mount surface of the substrate at a predetermined length; and an insertion part bent from the support part, and inserted into the lead hole of the substrate.

According to the present invention, two or more leads are provided on the electronic component main body.

According to the present invention, the lead is bent three to six times.

According to the present invention, an allowance protruding from a surface of the substrate opposite to the electronic-component mount surface of the substrate is provided on a tip end of the insertion part of the lead, the allowance being bent toward a side of the lead opposite to the base part of the lead.

According to the present invention, a length of the insertion part of the lead is set according to a thickness of the substrate.

### [Effect of the Invention]

According to the present invention, even if the electronic component is mounted on the substrate with the round portion of the electronic component opposing the substrate, the support part of the lead can support the electronic component main body in a predetermined attitude with respect to the substrate. It is also possible to suppress the allowance of the lead from becoming excessively large in dimensions.

### [Brief Description of the Drawings]

[Fig.1] Fig. 1 is a partially cross-sectional front view showing an electronic component on-substrate mounting structure according to an embodiment of the present invention.
[Fig.2] Figs. 2(A) and 2(B) are perspective views showing other types of leads according to the embodiment.
[Fig.3] Fig. 3 is a partially cross-sectional front view showing a modification of the embodiment.
[Fig.4] Fig. 4 is a partially cross-sectional front view showing another modification of the embodiment.
[Fig.5] Fig. 5 is a perspective view showing two leads each having a support part and the like provided by being bent four times.
[Fig.6] Fig. 6 is a perspective view showing two leads each having a support part and the like provided by being bent five times.
[Fig.7] Fig. 7 is a perspective view showing two leads each having a support part and the like provided by being bent six times.
[Fig.8] Fig. 8 is a partially cross-sectional front view showing an electronic component on-substrate mounting structure according to a conventional technique.
[Fig.9] Fig. 9 is a partially cross-sectional front view showing a state in which an electronic component is inclined with respect to a predetermined attitude according to the conventional technique.
[Fig.10] Fig. 10(A) shows a mounted state if the electronic component has normal finished dimensions according to the conventional technique, and Fig. 10(B) shows a mounted state if the electronic component has excessively small dimensions according to the conventional technique.

### [Best Mode for Carrying Out the Invention]

An electronic component on-substrate mounting structure according to an embodiment of the present invention will be described hereinafter with reference to the drawings.

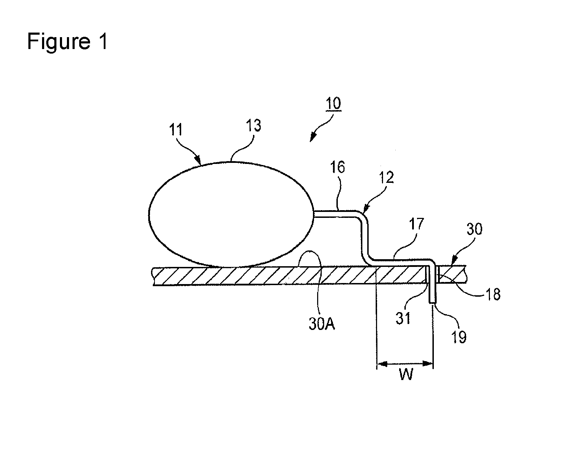

Fig. 1 shows an electronic component on-substrate mounting structure 10 according to the embodiment of the present invention. This electronic component on-substrate mounting structure 10 is configured to mount an electronic component 11 on a substrate 30 by inserting and soldering a lead 12 of the electronic component 11 into a lead hole 31 of the substrate 20.

An electronic component main body 13 of the electronic component 11 is, for example, one having a round external shape such as an electrolytic capacitor or a film capacitor. However, examples of the electronic component main body 13 possibly include one having a non-round external shape. In the present embodiment, the electronic component main body 13 is formed into an elliptical shape and mounted on the substrate 30 so that a longitudinal direction of the electronic component main body 13 is parallel to the substrate 30. By doing so, the round portion of the electronic component main body 13 is arranged to oppose the substrate 30.

The lead 12 of the electronic component 11 is obtained by lead forming. In this example, the lead 12 is bent three times each at an angle of about 90 degrees. By doing so, the lead 12 includes a base part 16 extending from one longitudinal end of the electronic component main body 13 in a longitudinal direction, a support part 17 bent twice each at an angle of about 90 degrees from a tip end of the base part 16 and supporting the electronic component main body 13 by causing a linear portion on a tip end side of the support part 17 to abut an electronic-component mount surface 30A of the substrate 30 at a predetermined length W, and an insertion part 18 bent once at an angle of about 90 degrees from a tip end of the support part 17 and inserted and soldered into the lead hole 31 of the substrate 30.

In this example, an allowance 19 protruding to a rear side of the substrate 30 is provided on a tip end side of the insertion part 18. In this example, the insertion part 18 and the allowance 19 are formed almost linearly.

According to this electronic component on-substrate mounting structure 10, the support part 17 of the lead 12 abuts the electronic-component mount surface 30A of the substrate 30 at the predetermined length W. It is, therefore, possible to support the electronic component main body 13 at a predetermined distance from the substrate 30 and in a predetermined attitude, which is, in this embodiment, a state of making the longitudinal direction of the electronic component main body 13 parallel to the substrate 30. Due to this, even if the electronic component main body 13 is tall, it is possible to make an overall height of the electronic component body 13 small.

Furthermore, the support part 17 and the insertion part 18 are bent at 90 degrees with respect to each other. Due to this, even if the electronic component main body 13 inclines with respect to the predetermined attitude, it is possible to avoid inserting the support part 17 into the lead hole 31 of the substrate 30. Therefore, even if a width of the electronic component main body 13 in a direction orthogonal to the longitudinal direction thereof changes for such a reason as a change in finished dimensions of the electronic component main body 13, it is possible to suppress the allowance 19 of the lead 12 from becoming excessively large in dimensions.

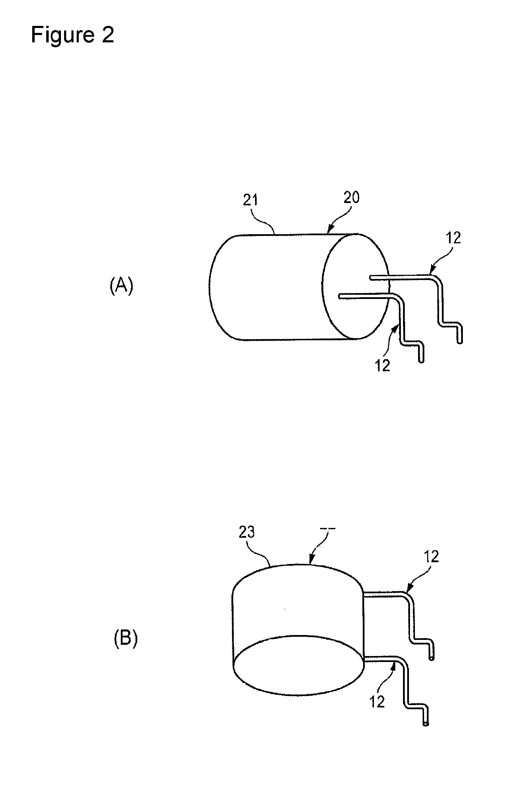

As shown in Figs. 2(A) and 2(B), the present invention is also applicable to an electronic component 20 or 22 having, for example, two leads 12 extending from an electronic component main body 21 or 23. In this case, the electronic component 20 or 22 can be supported more stably.

### (First Modification)

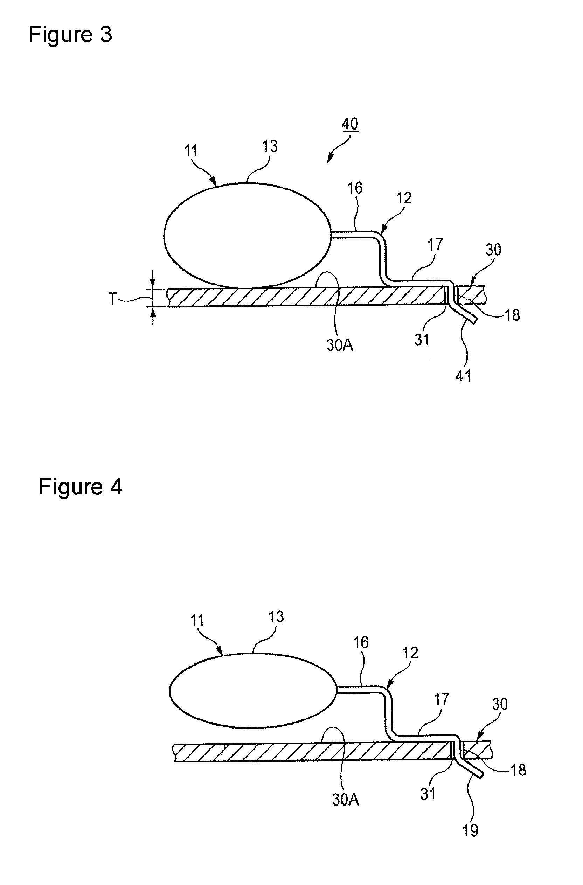

Fig. 3 shows an electronic component on-substrate mounting structure according to a modification of the embodiment.

Elements that are the same as those in Fig. 1 are denoted by the same reference numerals and not described herein. In an electronic component on-substrate mounting structure 40, an allowance 41 bent at about 45 degrees from a tip end of the insertion part 18 of the lead 12, protruding from a surface opposite to the electronic component main body 13, and extending to a side opposite to the electronic component main body 13 is provided. A length of the insertion part 18 is set according to a thickness T of the substrate 30. In this example, the length of the insertion part 18 is set almost equal to the thickness T of the substrate 30.

According to this electronic component on-substrate mounting structure 40, the allowance 19 of the lead 12 is caught in the substrate 30 when a force in a direction of separating from the substrate 30 acts on the electronic component main body 13. Therefore, it is possible to suppress the lead 12 from falling out of the lead hole 31.

Furthermore, since the length of the insertion part 18 is set according to the thickness T of the substrate 30, which means, in this modification, set almost equal to the thickness T. The electronic component 11 can be, therefore, stably mounted on the substrate 30.

Moreover, as shown in Fig. 4, the electronic component 11 can be mounted on the substrate 30 in a state in which the electronic component main body 13 is apart from the electronic-component mount surface 30A of the substrate 30. Further, the electronic component 11 can be mounted on the substrate 30 in a state in which the electronic component main body 13 abuts the electronic-component mount surface 30A.

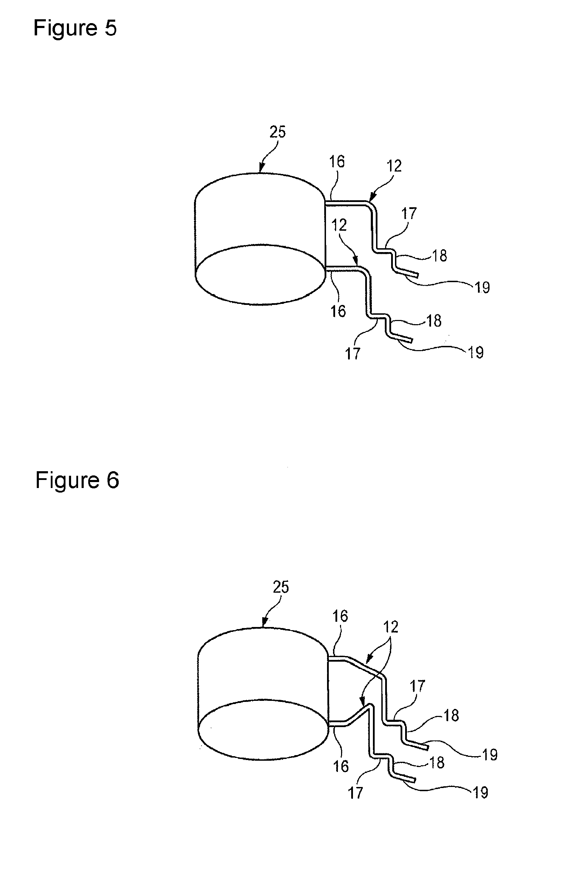

Furthermore, as shown in Figs. 5 to 7, by bending the lead 12 of an electronic component 25 four or sixth times, the base part 16, the support part 17, the insertion part 18, and the allowance 19 can be provided. It is thereby possible to form the lead 12 suited for a mounted state or the like of the electronic component 25 without greatly increasing the number of machining times.
Alternatively, the base part 16 to the allowance 19 can be provided by bending the lead 12 seven or more times.

### [Description of Reference Numerals]

- 10: On-substrate mounting structure
- 11: Electronic component
- 12: Lead
- 13: Electronic component main body
- 16: Base part
- 17: Support part
- 18: Insertion part
- 19: Allowance
- 20: Electronic component
- 21: Electronic component main body
- 25: Electronic component
- 30: Substrate
- 30A: Electronic-component mount surface
- 31: Lead hole
- 40: Electronic component on-substrate mounting structure
- 41: Allowance
- 100: Electronic component
- 101: Electronic component main body
- 102: Lead
- 110: Substrate
- 111: Lead hole

## Claims

1. An electronic component on-substrate mounting structure for mounting an electronic component on a substrate by inserting a lead of the electronic component into a lead hole of the substrate, wherein
the lead includes:
a base part extending from the electronic component main body;
a support part supporting the electronic component by abutting on an electronic-component mount surface of the substrate at a predetermined length; and
an insertion part bent from the support part, and inserted into the lead hole of the substrate.

2. The electronic component on-substrate mounting structure according to claim 1, wherein
two or more leads are provided on the electronic component main body.

3. The electronic component on-substrate mounting structure according to claim 1 or 2, wherein
the lead is bent three to six times.

4. The electronic component on-substrate mounting structure according to claim 3, wherein
an allowance protruding to a surface of the substrate opposite to the electronic-component mount surface of the substrate is provided in the insertion part of the lead, the allowance being bent toward a side of the lead opposite to the base part of the lead.

5. The electronic component on-substrate mounting structure according to claim 4, wherein
a length of the insertion part of the lead is set according to a thickness of the substrate.
